# FASCICULE DE BREVET EUROPEEN

(11) **EP 1 859 070 B1**
(45) Date de publication et mention de la délivrance du brevet: **21.12.2011**
(21) Numéro de dépôt: 06709334.4
(22) Date de dépôt: 16.02.2006
(51) Int. Cl.: C23C 14/16, A47J 36/02

(54) **SURFACE DE CUISSON FACILE A NETTOYER ET USTENSILE DE CUISINE COMPORTANT UNE TELLE SURFACE**
LEICHT ZU REINIGENDE KOCHFLÄCHE UND KÜCHENGERÄT DAMIT
EASY-TO-CLEAN COOKING SURFACE AND KITCHEN UTENSIL COMPRISING SAME

(30) Priorité: 15.03.2005 FR 0502540
(43) Date de publication de la demande: 28.11.2007
(73) Titulaire: SEB S.A., 69130 Ecully (FR)
(72) Inventeur: TUFFE, Stéphane, F-73160 Cognin (FR); COUDURIER, Alain, F-73410 Albens (FR)
(86) Numéro de dépôt international: PCT/FR2006/000360
(87) Numéro de publication internationale: WO 2006/097589

(56) Documents cités:
- FR-A- 2 848 797
- PATENT ABSTRACTS OF JAPAN vol. 008, no. 250 (E-279), 16 novembre 1984 (1984-11-16) & JP 59 125607 A (FUJITSU KK), 20 juillet 1984 (1984-07-20)
- PATENT ABSTRACTS OF JAPAN vol. 1999, no. 13, 30 novembre 1999 (1999-11-30) & JP 11 217668 A (SANYO SPECIAL STEEL CO LTD), 10 août 1999 (1999-08-10)

## Description

La présente invention concerne le domaine des articles destinés à la préparation et à la cuisson des aliments et plus particulièrement la surface de cuisson de ces articles en contact avec les aliments à traiter.

Depuis de nombreuses années, des efforts importants ont été développés afin de faciliter la préparation quotidienne des repas. Parmi les progrès notables, les revêtements à base de polymères fluorocarbonés en tant que revêtement anti-adhésif dans les ustensiles de cuisine se sont rapidement développés depuis la fin des années 1950. De tels revêtements sont mondialement connus depuis que le procédé présenté dans le brevet FR 1120749 a permis une fixation sûre de tels revêtements sur des métaux divers, tel l'aluminium.

Toutefois, de tels revêtements restent fragiles et résistent mal à la rayure. Ainsi, des astuces ont été développées afin de renforcer mécaniquement la couche sur son support. De nombreux brevets de perfectionnement décrivent des méthodes et moyens permettant d'accroître la résistance aux rayures de tels revêtements, en agissant sur le revêtement et/ou sur le substrat. Malgré tout, de tels revêtements restent sensibles à l'usage répété de matériaux métalliques aiguisés ou pointus, tels des couteaux ou fourchettes.

Parallèlement, des développements ont été menés sur des surfaces résistantes mécaniquement dont on a essayé d'améliorer la facilité de nettoyage. Des dépôts métalliques, tels le chromage sur inox, les quasi-cristaux, ou non métalliques (silicates,...) sont ainsi apparus. Les résultats restent toutefois décevants, notamment en comparaison avec les revêtements de type PTFE.

On connaît également, par le document FR 2 848 797, une surface de cuisson composée en majorité de zirconium métallique, surface qui possède une très bonne dureté, dès lors que la couche est nitrurée ou carburée, présentant des facilités de nettoyage satisfaisantes mais sans atteindre la facilité de nettoyage des couches de type PTFE.

La présente invention vise à remédier aux inconvénients précités de l'art antérieur, en proposant une surface de cuisson aux caractéristiques améliorées de facilité de nettoyage, présentant durablement une réduction de l'adhérence des aliments lors de la cuisson, de résistance à la corrosion, tout en présentant une bonne tenue mécanique, et notamment une dureté élevée.

La présente invention est atteinte par une surface de cuisson d'aliment pour ustensile de cuisine ou appareil de cuisson, caractérisée en ce que cette surface de cuisson est un composé élaboré à partir d'un alliage dont les deux principaux constituants sont le zirconium et le cobalt

Les alliages métalliques à base de cobalt, sont connus pour leur bonne résistance à l'usure.

D'une manière surprenante, il a été constaté, au cours d'essais, que des alliages, à base de cobalt et de zirconium, présentaient également des propriétés de facilité de nettoyage lorsque de telles surfaces étaient utilisées en tant que surface de cuisson et que des denrées alimentaires restaient accrochées à la surface, par exemple après une calcination des produits mis à cuire. Cette facilité de nettoyage peut être exprimée par la possibilité d'enlever facilement des éléments carbonisés sur la surface de cuisson.

Cette facilité de nettoyage est complétée, lors de la réalisation du composé, par une augmentation de la dureté dudit composé.

De plus, l'utilisation de zirconium permet d'obtenir des teintes de revêtement très variées qu'il n'est pas possible d'obtenir uniquement avec le cobalt. II est alors possible de définir une couleur de revêtement permettant d'identifier clairement, pour l'utilisateur, que le revêtement utilisé est spécifique et correspond à un revêtement "facile à nettoyer". On peut même envisager de relier les différentes teintes aux résultats des tests de facilité de nettoyage des surfaces de cuisson en fonction des aliments, afin que ce code de couleur permette aux utilisateurs d'identifier facilement la bonne surface de cuisson pour faire cuire un type d'aliment donné (oeufs, poissons, viande,...).

Avantageusement, l'alliage comporte essentiellement du zirconium, du cobalt et du chrome. Les alliages de cobalt et de chrome, tels les Alacrite^{®}, sont généralement connus pour leur résistance exceptionnelle à la corrosion (essentiellement par le chrome), et leur bonne résistance à l'usure (essentiellement par le cobalt). Ils sont essentiellement utilisés, en mécanique, en garnissage intérieur de paliers de pistons. Certaines nuances sont utilisées dans le domaine médical pour la réalisation d'implants et de prothèses.
La présence de chrome permet donc de renforcer la tenue de la surface de cuisson aux agents chimiques et à la corrosion.

L'élaboration de la surface de cuisson comporte une étape de dépôt des constituants, en une épaisseur appropriée, sur un. substrat, suivie d'une nitruration des constituants. Une telle nitruration, essentiellement du zirconium, permet d'augmenter considérablement la dureté de la surface de cuisson, tout en apportant de la diversité dans les teintes obtenues, essentiellement en jouant sur la stoechiométrie du nitrure de zirconium.

Avantageusement, l'élaboration de ladite surface comporte une étape de carburation ou de carbonitruration en surface après l'étape de nitruration, permettant d'augmenter davantage la dureté en surface de la couche, pour la rendre presque insensible à la rayure, sans altérer ses propriétés de facilité de nettoyage. Par ailleurs, l'étape de nitruration permet une bonne adhérence de la couche de carbure ou de carbonitrure de Co/Cr/Zr. Il est en effet connu par ailleurs, qu'il est très difficile de faire adhérer une couche de carbure ou de carbonitrure sur un substrat de type aluminium ou inox sans couché intermédiaire. Par ailleurs, la vitesse de dépôt d'une couche de carbure est nettement supérieure à la vitesse de dépôt d'une couche de nitrure.

Le gradient de composition ainsi obtenu allie les propriétés de facilité de nettoyage des surfaces en alliage Co/Cr au potentiel élevé de durcissement, de coloration et de résistance à la corrosion des couches de nitrure, carbure et carbonitrure de zirconium. Les duretés obtenues peuvent aller jusqu'à 2500 Vickers pour un carbure de zirconium.

Selon un mode préféré d'élaboration, le dépôt des constituants sur un substrat sera un dépôt physique en phase vapeur à partir d'une ou plusieurs cible(s) massive(s). Dans ce dernier cas la cible peut être obtenue par assemblage sur un substrat de cuivre d'une ou plusieurs tôle(s) ou plaque(s) de matériau ayant la composition recherchée, lesdites tôles ou plaques étant obtenues soit par frittage de poudre ou projection thermique de poudre, soit issues de coulée. Ces cibles constituent donc la source des matériaux qui seront déposés sur la surface de cuisson. D'une manière générale, toutes les techniques de dépôt physique en phase vapeur peuvent être utilisées.

Cette mise en oeuvre présente l'avantage d'utiliser peu de matière et de pouvoir ajuster une faible épaisseur de matériau sur le substrat en vue de réaliser la surface de cuisson. Cette technique de dépôt permet, par ailleurs, d'obtenir des dépôts en forte cohésion avec le substrat sur lequel ils sont déposés. Les risques de décollement du dépôt au cours de l'utilisation sont ainsi minimisés.

Le substrat peut être composé d'une ou plusieurs tôle(s) métallique(s) des matériaux suivants : aluminium, inox, fonte, acier, cuivre.

D'autres avantages issus des essais apparaîtront à la lecture de la description qui va suivre, en relation avec un exemple d'illustration de la présente invention donné à titre d'exemple non limitatif.

Les différents exemples de réalisation de l'invention concernent un dépôt, sur un substrat inox, par PVD, d'un alliage Co/Zr en utilisant les quatre points eutectiques du diagramme binaire du Co/Zr. Le pourcentage, en poids, du zirconium, pour ces quatre eutectiques, est donc de 14 %, 57,5 %, 74 % et 85 %. Une face de ce dépôt a subi un traitement de surface mécanique, avant la réalisation d'essais, afin de la rendre similaire à d'autres surfaces de cuisson pour que les essais d'évaluation de la facilité à nettoyer une telle surface, dans une utilisation de cuisson domestique, puissent être comparés. L'épaisseur déposée est de l'ordre de quelques microns.

Après le dépôt des constituants, la couche a subi une nitruration, puis une carbonitruration. Plus la phase de carbonitruration est longue, plus la surface sera dure.

Le système d'évaluation de la facilité de nettoyage permet de quantifier les capacités d'une surface de cuisson à retrouver son aspect d'origine après usage. Ce système d'évaluation comprend les étapes suivantes :
- la surface est localement recouverte d'un mélange alimentaire de composition connue,
- ce mélange est carbonisé dans un four dans des conditions définies, par exemple 210 °C pendant 20 minutes,
- après refroidissement, la surface est mise à tremper pendant un temps contrôlé dans un mélange d'eau et de détergent,
- un tampon abrasif est ensuite appliqué sous une contrainte définie à l'aide d'un appareil à abraser (plynomètre) sur la surface souillée dans un mouvement de va-et-vient pendant un nombre donné de cycles,
- le pourcentage de la surface correctement nettoyée est noté et caractérise la facilité de nettoyage de la surface de cuisson.

Les essais menés sur différents types de surface permettent ainsi d'évaluer comparativement la qualité des surfaces quant à leur facilité de nettoyage.
Bien entendu, les essais sont réalisés en respectant les mêmes paramètres pour chaque étape du système d'évaluation : même mélange alimentaire, même surface d'application du mélange alimentaire, même température de carbonisation,...

Le tableau comparatif suivant montre les résultats obtenus sur trois surfaces de cuisson différentes, à savoir un inox poli, un quasi-cristaux, et l'alliage cobalt / zirconium selon l'un des eutectiques cités, déposé sur inox, nitruré puis carbonitruré, tel que précédemment décrit, après polissage, dans un test sévère avec une composition alimentaire à base de lait et de riz réputée comme difficile à nettoyer une fois carbonisée. Un tel test permet ainsi de bien mettre en évidence les différences entre la qualité de nettoyage des surfaces:

| | Inox poli | Quasi-cristaux | Alliage Co/Zr nitruré/carbonitruré sur inox |
|---|---|---|---|
| Quantité de résidu carbonisé enlevée | 50% | 60% | 90 % |

Le tableau montre sans ambiguïté les résultats très intéressants obtenus avec l'alliage Co / Zr déposé sur inox, et notamment les résultats comparés à d'autres surfaces de cuisson. D'autres tests conduits sur une base aluminium montrent des résultats analogues.

Il est à noter que le nombre de cycles d'abrasion sur le plynomètre a été fixé à 18. Ce nombre réduit de cycles met bien en évidence la qualité de facilité de nettoyage de la surface selon l'invention puisqu'il ne reste plus que 10 % de la surface souillée après 18 mouvements de va-et-vient du tampon abrasif.

Des essais répétitifs après nettoyage complet de la surface montrent que la facilité de nettoyage de l'alliage présenté n'est pas altérée.

Lorsque la mise en oeuvre de l'invention implique l'utilisation d'un substrat, celui-ci est alors composé d'une ou plusieurs tôle(s) métallique(s) des matériaux suivants : aluminium, inox, fonte, acier, cuivre.

## Revendications

1. Surface de cuisson d'aliment pour ustensile de cuisine ou appareil de cuisson, **caractérisée en ce que** cette surface de cuisson est un composé élaboré à partir d'un alliage dont les deux principaux constituants sont le zirconium et le cobalt.

2. Surface de cuisson d'aliment pour ustensile de cuisine ou appareil de cuisson selon la revendication précédente, **caractérisée en ce que** les trois principaux constituants de l'alliage sont le zirconium, le cobalt et le chrome.

3. Surface de cuisson d'aliment pour ustensile de cuisine ou appareil de cuisson selon l'une des revendications précédentes, dont l'élaboration est **caractérisée par** une étape de nitruration de l'alliage après dépôt des constituants, en une épaisseur appropriée, sur un substrat.

4. Surface de cuisson d'aliment pour ustensile de cuisine ou appareil de cuisson selon la revendication précédente, **caractérisée en ce que** l'élaboration de ladite surface comporte une étape de carburation ou de carbonitruration en surface après l'étape de nitruration.

5. Surface de cuisson d'aliment pour ustensile de cuisine ou appareil de cuisson selon la revendication 3, **caractérisée en ce que** le dépôt est réalisé par dépôt physique en phase vapeur à partir d'une ou plusieurs cible(s) massive(s).

6. Surface de cuisson d'aliment pour ustensile de cuisine ou appareil de cuisson selon la revendication précédente, **caractérisée en ce que** le dépôt est réalisé à partir d'une cible obtenue par assemblage sur un substrat de cuivre d'une ou plusieurs tôle(s) ou plaque(s) de matériau ayant la composition recherchée, lesdites tôles ou plaques étant obtenues soit par frittage de poudre ou projection thermique de poudre, soit issues de coulée.

7. Surface de cuisson d'aliment pour ustensile de cuisine ou appareil de cuisson selon la revendication 3, **caractérisée en ce que** le substrat est composé d'une ou plusieurs tôle(s) métallique(s) des matériaux suivants : aluminium, inox, fonte, acier, cuivre.

8. Ustensile de cuisine ou appareil de cuisson comportant une surface de cuisson d'aliment conforme à l'une des revendications 1 à 7.

## Claims

1. A food cooking surface for kitchen utensils or cooking appliances, **characterised in that** this cooking surface is a compound made of an alloy whose two main components are zirconium and cobalt.

2. A food cooking surface for kitchen utensils or cooking appliances according to the preceding claim, **characterised in that** the three main components of the alloy are zirconium, cobalt and chromium.

3. A food cooking surface for kitchen utensils or cooking appliances according to one of the preceding claims, whose production is **characterised in that** it includes a step of nitriding the alloy after the components are deposited in a suitable thickness on a substrate.

4. A food cooking surface for kitchen utensils or cooking appliances according to the preceding claim, **characterised in that** the production of said surface comprises a step of carburizing or carbonitriding on the surface after the nitriding step.

5. A food cooking surface for kitchen utensils or cooking appliances according to claim 3, **characterised in that** the deposition is made by physical vapour deposition from one or more large-size target(s).

6. A food cooking surface for kitchen utensils or cooking appliances according to the preceding claim, **characterised in that** the deposition is made from a target obtained by assembling, on a copper substrate, one or more sheet(s) or plate(s) of material having the desired composition, said sheets or plates being obtained either by powder sintering or thermal spraying of powder or by casting.

7. A food cooking surface for kitchen utensils or cooking appliances according to claim 3, **characterised in that** the substrate is composed of one or more metal sheet(s) of the following materials: aluminium, stainless steel, cast iron, steel, copper.

8. A kitchen utensil or cooking appliance comprising a food cooking surface conforming to one of claims 1 to 7.

## Patentansprüche

1. Kochfläche für Kochgeschirr oder ein Kochgerät, **dadurch gekennzeichnet, dass** diese Kochfläche ein Verbund ist, der aus einer Legierung hergestellt ist, deren zwei Hauptbestandteile Zirconium und Cobalt sind.

2. Kochfläche für Kochgeschirr oder ein Kochgerät nach dem vorhergehenden Anspruch, **dadurch gekennzeichnet, dass** die drei Hauptbestandteile der Legierung Zirconium, Cobalt und Chrom sind.

3. Kochfläche für Kochgeschirr oder ein Kochgerät nach einem der vorhergehenden Ansprüche, deren Herstellung durch einen Schritt des Nitrierens der Legierung nach Abscheidung der Bestandteile in einer entsprechenden Dicke auf einem Substrat gekennzeichnet ist.

4. Kochfläche für Kochgeschirr oder ein Kochgerät nach dem vorhergehenden Anspruch, **dadurch gekennzeichnet, dass** die Herstellung der Fläche einen Schritt des Aufkohlens oder des Carbonitrierens an der Oberfläche nach dem Schritt des Nitrierens umfasst.

5. Kochfläche für Kochgeschirr oder ein Kochgerät nach Anspruch 3, **dadurch gekennzeichnet, dass** die Abscheidung durch physikalische Gasphasenabscheidung ausgehend von einem oder mehreren massiven Target(s) erfolgt.

6. Kochfläche für Kochgeschirr oder ein Kochgerät nach dem vorhergehenden Anspruch, **dadurch gekennzeichnet, dass** die Abscheidung ausgehend von einem Target erfolgt, das durch Beschichten eines Kupfersubstrates mit einem oder mehreren Blechen oder Platten aus einem Material, das die gewünschte Zusammensetzung aufweist, erhalten wird, wobei die Bleche oder Platten entweder durch Pulversintern oder thermisches Pulverspritzen erhalten oder gegossen werden.

7. Kochfläche für Kochgeschirr oder ein Kochgerät nach Anspruch 3, **dadurch gekennzeichnet, dass** das Substrat aus einem oder mehreren Metallblechen folgender Materialien besteht: Aluminium, Edelstahl, Gusseisen, Stahl, Kupfer.

8. Kochgeschirr oder Kochgerät, umfassend eine Kochfläche nach einem der Ansprüche 1 bis 7.
